# EUROPEAN PATENT SPECIFICATION

(11) **EP 3 917 302 B1**
(45) Date of publication and mention of the grant of the patent: **01.05.2024**
(21) Application number: 19911230.1
(22) Date of filing: 25.01.2019
(51) Int. Cl.: H05K 13/08, H05K 13/04

(54) **FEEDER DETERMINATION METHOD AND FEEDER DETERMINATION DEVICE**
VERFAHREN UND VORRICHTUNG ZUR BESTIMMUNG EINES ZUFÜHRERS
PROCÉDÉ DE DÉTERMINATION DE DISPOSITIF D'ALIMENTATION ET DISPOSITIF DE DÉTERMINATION DE DISPOSITIF D'ALIMENTATION

(43) Date of publication of application: 01.12.2021
(73) Proprietor: Fuji Corporation, Chiryu-shi, Aichi 472-8686 (JP)
(72) Inventor: SUGIYAMA Kenji, Chiryu-shi, Aichi 472-8686 (JP); KOTANI Kazuya, Chiryu-shi, Aichi 472-8686 (JP)
(74) Representative: Grünecker Patent- und Rechtsanwälte PartG mbB
(86) International application number: PCT/JP2019/002423
(87) International publication number: WO 2020/152839

(56) References cited:
- EP-A1- 3 038 443
- WO-A1-2015/025383
- JP-A- 2009 123 893
- JP-A- 2009 123 894
- JP-A- 2009 272 377
- US-A1- 2018 192 522

## Description

### Technical Field

The present disclosure relates to a feeder determination method, for determining a feeder configured to supply a component used in a mounting operation of a component mounting machine, and a feeder determination device.

### Background Art

Technology for mass-producing board products by performing a board operation on a board on which printed wiring is applied has become widespread. A typical example of a board work machine for performing board work is a component mounting machine for performing a component mounting operation. Many component mounting machines are exchangeably equipped with a feeder that supplies components using a carrier tape. If the reliability of supplying the feeder is reduced, a pickup error would occur in which a component cannot be picked up by a suction nozzle, resulting in the waste of the component and degradation in production efficiency. Patent Document 1 discloses an example of a technology for suppressing this type of pickup error.

The feeder component-type determination method disclosed in Patent Document 1 includes a positional accuracy measurement step and a component-type determination step. In the positional accuracy measurement step, the positional accuracy of the supply position is measured for at least a portion of the feeder. In the component-type determination step, a combination of the feeder and the component-type of the carrier tape is determined based on the positional accuracy of the feeder and at least one of the external dimension and the allowable positional accuracy of the component. With such a configuration, it is said that the pickup error can be suppressed even for a very small component having a strict allowable positional accuracy so as to improve the production efficiency of the board product.

### Patent Literature

Patent Document 1: International Publication No. 2015/025383

### Summary of the Invention

### Technical Problem

In Patent Document 1, it is advantageous to be able to suppress pickup errors for a very small component having a strict allowable positional accuracy. However, it takes time and effort to measure the actual positional accuracy, that is, the supply quality of each feeder. Further, the state of the feeder changes as it is used and the supply quality changes accordingly. Accordingly, it is difficult to accurately manage the present supply quality of multiple feeders, and therefore management takes a great deal of effort. Further, feeders other than new feeders have been used in the past and have a performance result of components supply. Normally, there is a strong correlation between the supply performance record obtained when the feeder is used and the supply quality of the feeder.

JP2009123894A discloses a component supply method which takes out components supplied by tape feeders provided in a feeder installation area, by heads and mounts the components on a substrate. It is disclosed that while a rank being the capability index of the feeder is determined for each of the feeder in accordance with temporal variation of predetermined actual result data associated with actual component supply results, a request rank requested to produce the substrate is determined in advance based upon production conditions of the substrate and a feeder matching the request rank is installed in the feeder installation area and supplies the components.

US2018192522A1 discloses a component mounting system that includes a plurality of component supply devices each of which supplies components from a component supply position and a component mounter that sucks the components from the component supply position of each of the plurality of component supply devices with a plurality of nozzles to install the components onto a board. A suction position correction value for correcting a suction position shift from a regular suction position when each of the nozzles sucks the components from the component supply position is calculated. The suction position is corrected based on the suction position correction value to suck the components. A suction position shift amount from the regular suction position is calculated. A feeder evaluation value, which is a sum of the suction position correction value and the suction position shift amount, is calculated for each of the plurality of component supply devices. EP3038443A1 discloses a feeder component type determination method which determines combinations of a plurality of tape feeders and a plurality of component types of components. The method includes a positional precision measurement step of measuring a positional precision for at least a portion of the tape feeders, and a component type determination step of determining the combinations of the tape feeders and the component types based on the positional precision of the tape feeders and at least one of component external dimensions which are determined according to the component type of the components and an allowable positional precision. [0006] However, as described in Patent Document 1, the supply quality required for a feeder generally differs depending on the size and type of the component. For this reason, it is difficult to determine the appropriate feeder to match with the size and type of the component.

It is an object of the present specification to provide a feeder determination method and a feeder determination device capable of determining the appropriate feeder to match with the size or type of the component when determining a feeder to be used in a mounting operation of a component mounting machine.

### Solution to Problem

This object is solved by the subject matter of the independent claims.

Embodiments are defined by the dependent claims.

The present specification discloses a feeder determination method, comprising: a performance result registration step of registering performance result data in a database associating a size or type of a component used in a mounting operation that has been performed in a component mounting machine with identification information of a feeder that supplied the component using a carrier tape; a performance result search step of searching for whether candidate data matches any of the performance result data in the database, the candidate data being a combination of a size or type of a component used in a mounting operation to be performed; a performance record-based determination step of determining a combination of a size or type of a component and a feeder based on a supply performance record in the mounting operation that has been performed with the feeder that is to become a candidate when the candidate data matches at least one piece of the performance result data; wherein the supply performance record of the feeder is related to a recorded performance result pickup rate for the combined size or type of a component;
and a quality-based determination step of determining a combination of a size or type of a component and a feeder based on a supply quality of the feeder when the candidate data does not match any of the performance result data, wherein the supply quality of the feeder is related to an ability of positional accuracy of the feeder.

The present specification also discloses a feeder determination device, comprising: a performance result registration section configured to register performance result data in a database associating a size or type of a component used in a mounting operation that has been performed in a component mounting machine with identification information of a feeder that supplied the component using a carrier tape; a performance result search section configured to search for whether candidate data matches any of the performance result data in the database, the candidate data being a combination of a size or type of a component used in a mounting operation to be performed with identification information of a candidate feeder to supply the component; a performance record-based determination section configured to determine a combination of a size or type of a component and a feeder based on a supply performance record in the mounting operation that has been performed with the feeder when the candidate data matches at least one piece of the performance result data; wherein the supply performance record of the feeder is related to a recorded performance result pickup rate for the combined size or type of a component;
and a quality-based determination section configured to determine a combination of a size or type of a component and a feeder based on a supply quality of the feeder when the candidate data does not match any of the performance result data, wherein the supply quality of the feeder is related to an ability of positional accuracy of the feeder.

### Advantageous Effect of the Invention

In the feeder determination method and the feeder determination device disclosed in the present specification, when there is a performance results in which a size or type of a component used in a mounting operation to be performed is used in combination with a candidate feeder, the combination of the size or type of the component and the feeder is determined based on the supply performance record of the feeder. Therefore, an appropriate combination is reliably determined based on the supply performance record of the highly reliable feeder.

Further, when there is no performance result, a combination of a size or type of a component and a feeder is determined based on the supply quality of a feeder. Therefore, an appropriate combination is determined based on the supply quality having a large correlation with supply performance records. Accordingly, an appropriate feeder corresponding to the size or type of the component is determined regardless of whether there is a performance result.

### Brief Description of Drawings

Fig. 1 is a plan view schematically showing a configuration of a component mounting machine to which a feeder determination method of a first embodiment is applied.
Fig. 2 is a block diagram showing a control configuration of the component mounting device and a management computer.
Fig. 3 is a perspective view schematically showing a method for obtaining the supply quality of a feeder.
Fig. 4 is an operational flowchart showing the feeder determination method of the embodiment.
Fig. 5 is a detailed flowchart of a performance record-based determination step within the operational sequence.
Fig. 6 is a detailed flowchart of a quality-based determination step within the operational sequence.
Fig. 7 is a diagram showing a table of simple examples of supply performance records and supply qualities of candidate feeders.
Fig. 8 is a table showing a method for determining the combination of component size and feeder based on the supply performance records and supply qualities exemplified in Fig. 7.
Fig. 9 is a partial detailed view of a table showing supply performance records individually obtained for a combination of a feeder and a suction nozzle in a second embodiment.

### Description of Embodiments

### 1. Configuration of component mounting device 1

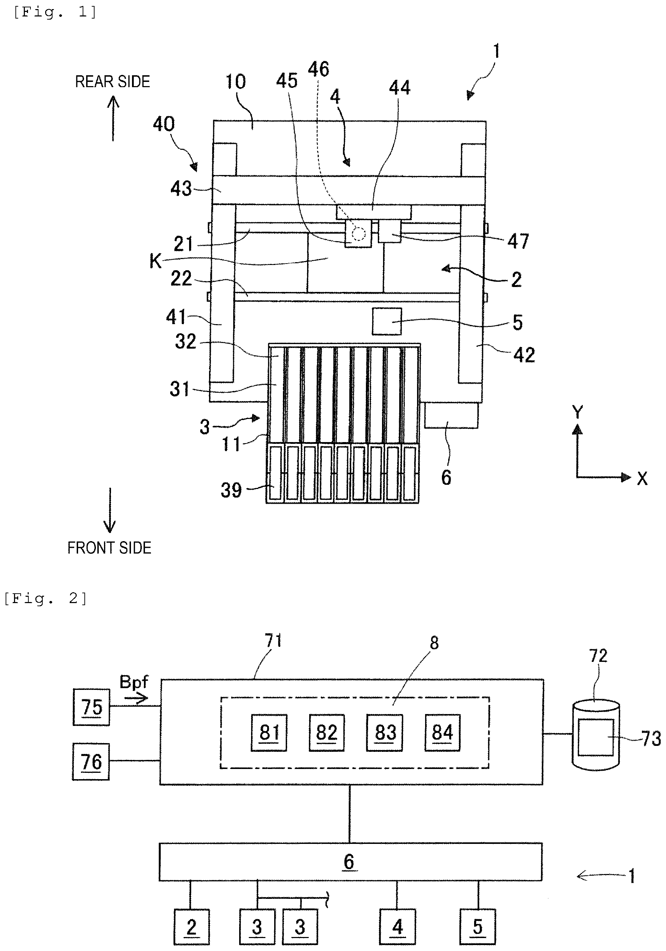

First, a configuration example of component mounting machine 1 to which the feeder determination method of the first embodiment is applied will be described with reference to Fig. 1. Component mounting machine 1 performs a mounting operation of mounting a component onto board K. The direction from left to right in Fig. 1 in which board K is conveyed is the X-axis direction, and the direction from the bottom (front side) of the paper surface toward the top (rear side) is the Y-axis direction. Component mounting machine 1 is configured by assembling board conveyance device 2, multiple feeders 3, component transfer device 4, part camera 5, control device 6, and the like on base 10.

Board conveyance device 2 includes a pair of guide rails 21,22, a pair of conveyor belts, a board clamping mechanism, and the like. The conveyor belts convey in board K to the work execution position by rotating along guide rails 21, 22 with board K placed on the conveyor belts. The board clamping mechanism pushes up board K at the work execution position to clamp and position board K. When the mounting operation of the component is finished, the board clamping mechanism releases board K. Subsequently, conveyor belts convey board K out.

Feeders 3 are detachably installed in multiple groove-shaped slots provided in pallet member 11 on base 10. In each feeder 3, tape reel 39 is loaded from the front side of main body section 31. Predetermined supply position 32 for supplying components is set at the top portion in the rear vicinity of main body section 31. A carrier tape, in which components are accommodated in multiple cavities, is wound around tape reel 39. Feeder 3 intermittently feeds the carrier tape by a tape feeding mechanism (not shown) to set a component at supply position 32. In this way, feeder 3 sequentially supplies components.

Feeder 3 is assigned with identification information and managed. The identification information is displayed with a label or the like on which a barcode is printed. Further, a control section (not shown) of feeder 3 holds identification information and has a function of transmitting the identification information using communication. Further, as for the information on the type of component accommodated in tape reel 39, a label on which a barcode is printed is affixed to tape reel 39 and displayed. The identification information and the information on the type of component may be assigned by a display location and a display method other those described above.

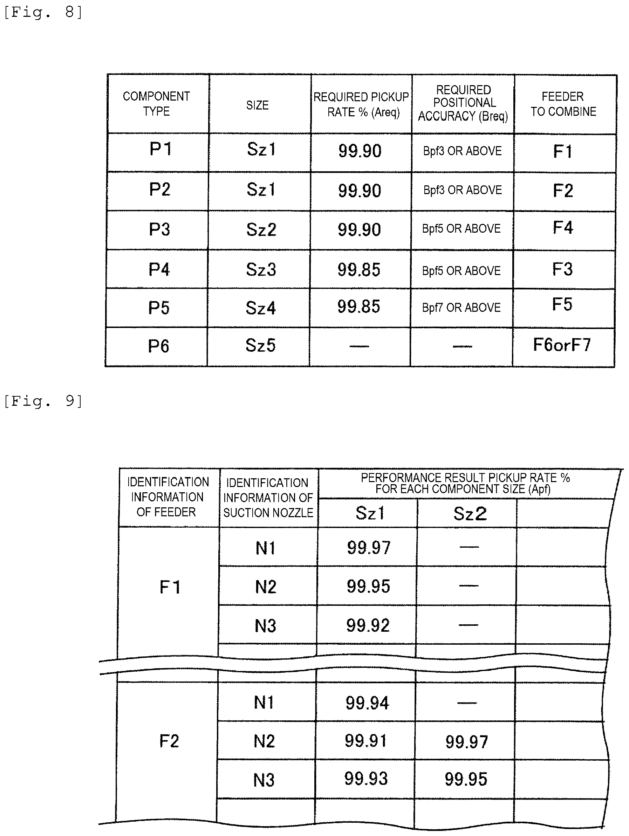

The width of the carrier tape are of multiple types varying in a stepwise manner depending on the size of the components. Feeder 3 may be of multiple types corresponding to the width of the carrier tape. Even if the width of the carrier tapes is the same, the sizes of the components may differ. In many carrier tapes, the smaller the size of the component, the higher the required positional accuracy Breq (see Fig. 8) required for supply position 32 when a component is picked up by suction nozzle 46 (described later).

Component transfer device 4 is disposed above board conveyance device 2 and feeder 3. Component transfer device 4 collects components from feeder 3 and mounts the components onto board K. Component transfer device 4 includes head driving mechanism 40, moving base 44, mounting head 45, suction nozzle 46, mark camera 47, and the like. Head driving mechanism 40 is configured to include a pair of Y-axis rails 41, 42, Y-axis slider 43, and a drive motor (not shown). Y-axis rails 41, 42 extend parallel to each other in the Y-axis direction and are spaced apart from each other. Y-axis slider 43 is long in the X-axis direction, is laid across both Y-axis rails 41, 42, and moves in the Y-axis direction. Moving base 44 is installed on Y-axis slider 43 and moves in the X-axis direction. Head driving mechanism 40 drives Y-axis slider 43 in the Y-axis direction and drives moving base 44 on Y-axis slider 43 in the X-axis direction.

Moving base 44 holds mounting head 45 and mark camera 47. Mounting head 45 holds one or more suction nozzles 46 on the lower side and is driven by head driving mechanism 40 to move in two horizontal directions. Suction nozzle 46 is operated to move up and down by being driven by lifting and lowering drive section (not shown). Suction nozzle 46 descends from above supply position 32 and executes a component pickup operation by supplying negative pressure. Suction nozzle 46 is driven to a position above board K and executes a component mounting operation by supplying a positive pressure. Mounting head 45 and suction nozzle 46 are of multiple types and are automatically or manually exchanged. By imaging a position mark affixed to positioned board K, mark camera 47 detects an accurate work execution position for board K.

Part camera 5 is provided on the top face of base 10, between board conveyance device 2 and feeder 3, and faces upward. Part camera 5 captures an image of a component while suction nozzle 46 is picking up the component midway during the transit of moving base 44 from feeder 3 to board K. The acquired image data is subjected to image processing so that the pickup orientation of the component is acquired as a result of the image processing. The image processing result is reflected in the mounting operation of suction nozzle 46.

Control device 6 is assembled to base 10, and the arrangement position of control device 6 is not particularly limited. Control device 6 is configured by a computer device having a CPU and operated with software. Control device 6 may be configured such that multiple CPUs are distributed inside. Control device 6 controls the mounting operation of the component in accordance with a mounting sequence stored in advance. The mounting sequence differs depending on the type of board product to be manufactured.

### 2. Control configuration of component mounting machine 1 and management computer 71

As shown in Fig. 2, control device 6 controls board conveyance device 2, feeders 3, component transfer device 4, and part camera 5. Management computer 71 is provided as an upper-level control device for controlling component mounting machine 1. Control device 6 of component mounting machine 1 and management computer 71 are connected to each other by wired or wireless communication. Management computer 71 transmits a command relating to the mounting operation of the board product to control device 6. Control device 6 transmits the information related to the progress of the mounting operation to management computer 71. Management computer 71 controls multiple component mounting machines 1 and other types of board work machines together.

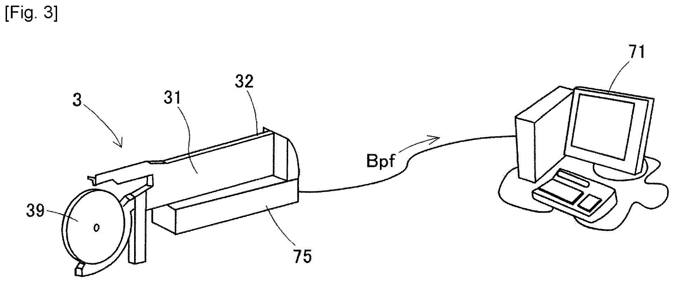

Management computer 71 has a database 72 for storing various data required for management. As shown in Fig. 2 and Fig. 3, management computer 71 is communicably connected to measurement jig 75. Measurement jig 75 is a jig for measuring the supply quality of feeder 3. In the first embodiment, the supply quality is expressed with the ability of positional accuracy Bpf indicating the positional accuracy when a carrier tape is fed to set a component at predetermined supply position 32.

When an operator installs feeder 3 in measurement jig 75 and operates the measurement start button, measurement jig 75 performs a measurement. Specifically, measurement jig 75 includes an instruction section, a measurement calculator, and a communication section, all of which are not shown in the figure. The instruction section issues an instruction to the installed feeder 3 to control the feeding of the carrier tape. The measurement calculator measures the positional accuracy of supply position 32 after the carrier tape is fed to calculate the ability of positional accuracy Bpf. The measurement calculator performs, for example, measurements multiple times, averages the multiple positional accuracies, and sets the averaged positional accuracy as the ability of positional accuracy Bpf. The communication section acquires identification information from feeder 3, associates the identification information with the ability of positional accuracy Bpf, and transmits the information to management computer 71. Management computer 71 stores, in database 72, data in which identification information and ability of positional accuracy Bpf are associated with each other.

The ability of positional accuracy Bpf may be acquired by measuring during the mounting operation which is performed upon installing feeder 3 in component mounting machine 1. That is, the image data acquired by part camera 5 includes information regarding the positional relationship between suction nozzle 46 and the component. Accordingly, by performing image processing on the image data, it is possible to obtain the ability of position accuracy Bpf. In a qualitative example, a high ability of positional accuracy Bpf is obtained when the center of the picked up component substantially coincides with the center of suction nozzle 46, whereas a low ability of positional accuracy Bpf is obtained when the centers do not coincide with each other.

Management computer 71 also includes barcode reader 76 operated by an operator. Barcode reader 76 reads a barcode displayed on feeder 3 and acquires the identification information of feeder 3. In addition, barcode reader 76 reads a barcode displayed on the reel and acquires information on the component type. The information acquired by barcode reader 76 is stored in database 72. It should be noted that in a case where the display method of the identification information of feeder 3 and the information of component type is not a barcode, a device other than barcode reader 76 is used in correspondence with the display method.

### 3. Feeder determination method and feeder determination device 8 of the first embodiment

Next, a feeder determination method of the first embodiment will be described using a simple example. The feeder determination method of the first embodiment is executed by control from feeder determination device 8 of the embodiment. As shown in Fig. 2, feeder determination device 8 is achieved with software of management computer 71. Feeder determination device 8 includes four functional sections, that is, performance result registration section 81, performance result searching section 82, performance record-based determination section 83, and quality-based determination section 84. Each function of the four functional sections will be described with the following operational sequence.

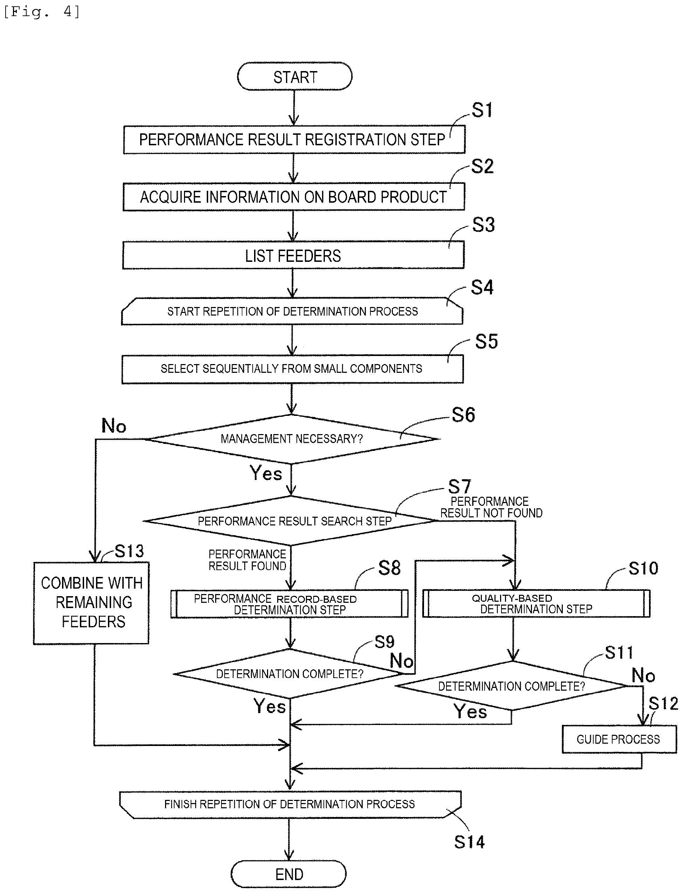

Feeder determination device 8 controls the execution of the operation sequence shown in Fig. 4. In the performance result registration step S1 in Fig. 4, performance result registration section 81 of feeder determination device 8 registers performance result data 73 in database 72. Performance result data 73 is data associating the type and size of the component used in the mounting operation that is performed in component mounting machine 1 with the identification information of feeder 3 that supplied the component. Performance result registration section 81 actually accumulates performance result data 73 every time component mounting machine 1 is activated.

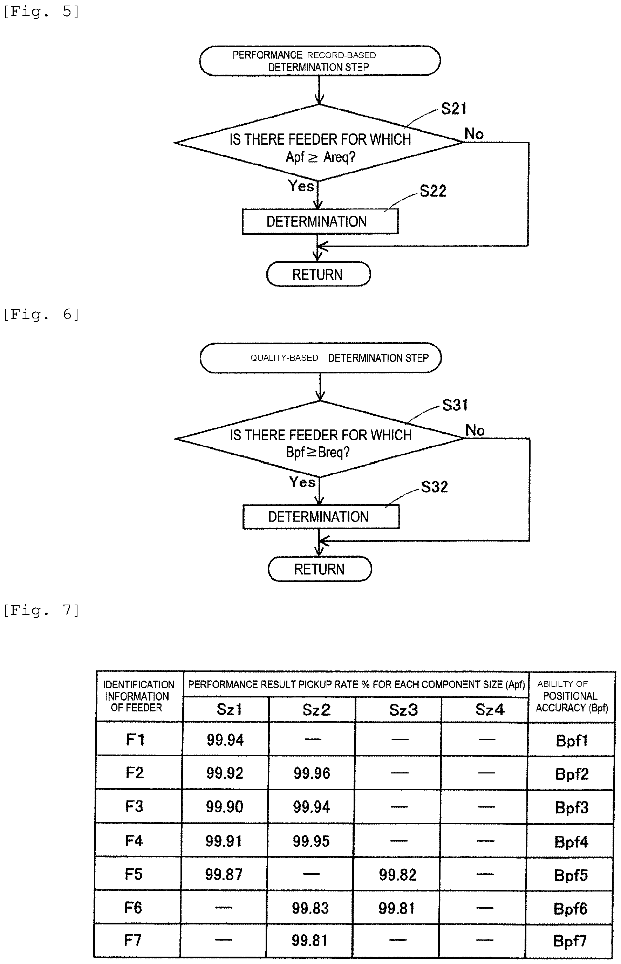

In Fig. 7, as a simple example, performance result data 73 of seven feeders 3 of identification information F1 to F7 are shown. Performance result data 73 not only associates the sizes of the components with the identification information of feeders 3 but also includes the supply performance records of the mounting operation. In the first embodiment, the supply performance record is expressed with a performance result pickup rate Apf indicating the probability that suction nozzle 46 in charge of the mounting operation succeeds in picking up a component. The performance result pickup rate Apf is the pickup rate, by size, for each component size. Data such as the number of pickup operations or the number of successful pickup operations, on which the performance result pickup rate Apf is based, the identification information of mounting head 45 or suction nozzle 46 used, and the like are included in performance result data 73.

In Fig. 7, the size of the component is smallest in Sz1 and larger in the order of Sz2, Sz3, and Sz4. In feeder 3 of identification information F1, the performance result pickup rate Apf of the component of size Sz1 is 99.94%, and performance result data 73 of components of sizes Sz2 to Sz4 are not available. Horizontal lines are written in fields in which performance result data 73 is not stored. In feeder 3 of identification information F2, the performance result pickup rate Apf of components of size Sz1 is 99.92%, the performance result pickup rate Apf of components of size Sz2 is 99.96%, and there is no performance result data 73 for components of sizes Sz3 and Sz4. The description hereinafter, can be viewed in a similar way. In feeder 3 of identification information F7, the performance result pickup rate Apf of components of size Sz2 is 99.81%, and performance result data 73 of components of sizes Sz1, Sz3, and Sz4 are not available.

Further, the ability of positional accuracies Bpf of seven feeders 3 of identification information F1 to F7 are obtained using measurement jig 75. Here, it is assumed that the ability of positional accuracy Bpf sequentially decreases from the ability of positional accuracy Bpf1 to the ability of positional accuracy Bpf7 in accordance with the order of identification information F1 to F7 of feeder 3. That is, expressed as an inequality, Bpf1□Bpf2□Bpf3□Bpf4□Bpf5□Bpf6□Bpf7. There is a large correlation between the performance result pickup rate Apf and the ability of positional accuracy Bpf. However, in multiple feeders 3, the orders of the performance result pickup rate Apf and the ability of positional accuracy Bpf do not necessarily match with each other.

In the next step, S2, feeder determination device 8 acquires information on the type of board product to be produced next. Feeder determination device 8 recognizes the type of a component, size of a component, number of components to be mounted per board, and the like used in the mounting operation to be performed with reference to the mounting sequence in accordance with the type of board product. For example, feeder determination device 8 recognizes six types P1 to P6 and five sizes of components shown in Fig. 8.

The sizes of components of type P1 and type P2 are the same Sz1. The size of type P3 components is Sz2, the size of type P4 components is Sz3, the size of type P5 components is Sz4, and the size of type P6 components is Sz5. For components of sizes Sz1 to Sz4, the required pickup rate Areq required for favorable pickup operation of the component is set.

Specifically, the required pickup rate Areq is set to 99.90% for components of size Sz1 and size Sz2. For components of size Sz3 and size Sz4, the required pickup rate Areq is set to 99.85%. The required pickup rate Areq described above is an example, and different values may be set. The required pickup rate Areq is set higher as the size of the component becomes smaller.

In addition, as for the components of sizes Sz1 to Sz4, the required positional accuracy Breq required for favorable pickup operation of components is set. The required positional accuracy Breq is often set using a numerical value such as a tolerance. The required positional accuracy Breq is not a specific numerical value and is expressed as a relationship with the ability of positional accuracy Bpf of feeder 3.

For example, the required positional accuracy Breq of components of size Sz1 is set to be equal to or greater than the ability of positional accuracy Bpf3 of feeder 3 of identification information F3. The required positional accuracy Breq of components of sizes Sz2, Sz3 is set to be equal to or greater than the ability of positional accuracy Bpf5 of feeder 3 of identification information F5. The required positional accuracy Breq of components of size Sz4 is set to be equal to or greater than the ability of positional accuracy Bpf7 of feeder 3 of identification information F7. The required positional accuracy Breq is set higher as the size of the component becomes smaller.

Components of type P6 have a larger size Sz5 than components of types P1 to P5, and it has been found that the pickup operation is performed satisfactorily regardless of which feeder 3 the component is combined with. Accordingly, for a large component having size Sz5 or larger, the required pickup rate Areq and the required positional accuracy Breq are not set and are excluded from the management of feeder determination device 8. Conversely, small components having sizes Sz1 to Sz4 are managed by feeder determination device 8 to determine feeder 3 to be combined.

In the next step, S3, feeder determination device 8 lists feeders 3 that are candidates for supplying components for types P1 to P6. At this time, feeder determination device 8 excludes, from the candidates, feeders 3 that cannot be used immediately, for example, feeder 3 operating in another component mounting device or feeder 3 issued for maintenance. In the following description, a case where seven feeders 3 shown in Fig. 7 are candidates will be considered.

Next, feeder determination device 8 repeats the determination process from step S4 to step S14 for each component size. In step S5, feeder determination device 8 sequentially selects from components having small sizes. This means that components are sequentially selected from components having higher required positional accuracies Breq and required pickup rates Areq. In first step, S5, components of type P1 and type P2 of the smallest size Sz1 are selected. In the next step, S6, it is determined whether management of component of size Sz1 is necessary. Since management of components of size Sz1 is necessary, the execution of the operational sequence proceeds to the performance result search step, S7.

In the performance result search step S7, performance result searching section 82 searches for whether candidate data obtained by combining the size of a component used for the mounting operation to be performed and the identification information of feeder 3 that is a candidate to supply the component matches any of performance result data 73 in database 72. In the first performance result search step S7, candidate data obtained by combining size Sz1 of the component and identification information F1 to F7 of all feeders 3 can be considered. Among them, the candidate data obtained by combining size Sz1 and identification information F1 to F5 coincides with performance result data 73 (field in which the numerical value of the performance result pickup rate Apf is recorded) shown in Fig. 7. Accordingly, the execution of the operational sequence proceeds to the performance record-based determination step S8.

The details of the performance record-based determination step S8 are shown in Fig. 5. In step S21 in Fig. 5, performance record-based determination section 83 examines whether there is feeder 3 whose performance result pickup rate Apf is equal to or more than the required pickup rate Areq. In the first step, S21, the feeders of identification information F1 to F4 satisfy the condition that the performance result pickup rate Apf is higher than required pickup rate Areq of 99.90%. Accordingly, the execution of the operational sequence proceeds to step S22. It should be noted that the feeder of identification information F5 has a performance result pickup rate Apf of 99.87% and is lower than the required pickup rate Areq, and is excluded from the candidates.

In step S22, performance record-based determination section 83 employs a combination with feeder 3 having a higher performance result pickup rate Apf in order from the size having the higher required pickup rate Areq. In the first instance of step S22, performance record-based determination section 83 employs a combination of a component of type P1 of size Sz1 and feeder 3 of identification information F1 having the highest performance result pickup rate Apf of 99.94%. Performance record-based determination section 83 further employs a combination of a component of type P2 of size Sz1 and feeder 3 of identification information F2 having the second highest performance result pickup rate Apf of 99.92%.

The above-described employment result is shown in the rightmost column of the table in Fig. 8. It should be noted that feeder 3 may be replaced with multiple types of components having the same size. That is, a combination of a component of type P1 and feeder 3 of identification information F2, and a combination of a component of type P2 and feeder 3 of identification information F1 may be employed. Thereafter, the execution of the operational sequence is returned to step S9 in Fig. 4.

In step S9, it is determined whether feeders 3 for supplying components of types P1 and P2 have been determined. Since the determination has been completed as described in step S22, the execution of the operational sequence is returned to step S5.

In the second instance of step S5, a component of type P3 of the second smallest size Sz2 is selected. Thereafter, the execution of the operational sequence proceeds from step S6 to the performance result search step S7. In the second instance of performance result search step S7, candidate data obtained by combining size Sz2 of the component and identification information F3 to F7 (determined identification information F1, F2 are excluded) are conceivable. Among them, candidate data obtained by combining size Sz2 and identification information F3, F4, F6, F7 coincide with performance result data 73. Accordingly, the execution of the operational sequence proceeds to the performance record-based determination step S8.

In the detailed step S21 in the second instance of performance record-based determination step S8, the feeders of identification information F3, F4 satisfy the condition that the performance result pickup rate Apf is higher than 99.90% of the required pickup rate Areq. Accordingly, the execution of the operational sequence proceeds to step S22. The feeders of identification information F6, F7 do not satisfy the condition and are excluded from the candidates. In the second instance of step S22, performance record-based determination section 83 compares the performance result pickup rate Apf of 99.94% of identification information F3 with the performance result pickup rate Apf of 99.95% of identification information F4 and employs a combination of feeder 3 of the higher identification information F4 and a component of type P3 of size Sz2 (see the rightmost column in Fig. 8). Thereafter, the execution of the operational sequence is returned to step S5 via step S9.

In the third instance of step S5, a component of type P4 of the third smallest size Sz3 is selected. Thereafter, the execution of the operational sequence proceeds from step S6 to the performance result search step S7. In the third instance of performance result search step S7, candidate data obtained by combining size Sz3 of the component and identification information F3, F5 to F7 (determined identification information F1, F2, F4 are excluded) can be considered. Among them, the candidate data obtained by combining size Sz3 and identification information F5, F6 matches performance result data 73. Accordingly, the execution of the operational sequence proceeds to the performance record-based determination step S8.

In detailed step S21 in the third instance of performance record-based determination step S8, feeders of identification information F5 and F6 have actual pickup rates Apf of 99.82% and 99.81%, which are lower than the 99.85% of the required pickup rate Areq and do not satisfy the condition. That is, there is no feeder 3 that satisfies the ability of pickup rate Apf in order to satisfactorily perform the pickup operation. Accordingly, the execution of the operational sequence is returned to step S9 without passing through step S22. In step S9, since feeder 3 for supplying the component of type P4 is not determined, the execution of the operational sequence proceeds to the quality-based determination step S10.

The details of the quality-based determination step S10 are shown in Fig. 6. In step S31 in Fig. 6, quality-based determination section 84 examines whether there is a feeder 3 having an ability of positional accuracy Bpf higher than the required position accuracy Breq. The ability of position accuracy Bpf3 of feeder 3 of identification information F3 and the ability of position accuracy Bpf5 of feeder 3 of identification information F5 are equal to or greater than the required position accuracy Breq (=Bpf5 or more), and satisfy the condition. Accordingly, the execution of the operational sequence proceeds to step S32. The feeders of identification information F6, F7 do not satisfy the condition and are excluded from the candidates.

In step S32, quality-based determination section 84 employs the combination with feeder 3 having a higher actual positional accuracy Bpf in order from the size having the higher required positional accuracy Breq. Quality-based determination section 84 compares the ability of position accuracy Bpf3 of identification information F3 with the ability of position accuracy Bpf5 of identification information F5 and employs a combination of feeder 3 of the higher identification information F3 and a component of type P4 of size Sz3 (see the rightmost column in Fig. 8). Thereafter, the execution of the operational sequence is returned to step S11. In step S11, it is determined whether feeder 3 for supplying components of type P4 has been determined. Since the determination has been made as described in step S32, the execution of the operational sequence is returned to step S5.

In the fourth instance of step S5, a component of type P5 having the fourth smallest size Sz4 is selected. Thereafter, the execution of the operational sequence proceeds from step S6 to the performance result search step S7. In the fourth instance of performance result search step S7, candidate data obtained by combining size Sz4 of the component with identification information F5 to F7 (determined identification information F1 to F4 are excluded) are considered. Here, performance result data 73 of size Sz4 does not exist. Accordingly, the execution of the operational sequence is advanced to the quality-based determination step S10.

In detailed step S31 in the quality-based determination step S10, feeders 3 of identification information F5 to F7 have ability of positional accuracies Bpf5 to Bpf7 equal to or greater than the required positional accuracy Breq (=Bpf7 or more), and satisfies the condition. Accordingly, the execution of the operational sequence proceeds to step S32. In step S32, quality-based determination section 84 employs a combination of feeder 3 of identification information F5 having the highest ability of positional accuracy Bpf5 among the three candidates and the component of type P5 of size Sz4 (see the rightmost column in Fig. 8). Thereafter, the execution of the operational sequence is returned to step S5 via step S11.

If there is no feeder 3 that satisfies the condition in step S32, feeder 3 to be combined with the component of type P5 of size Sz4 is undetermined. In this case, the execution of the operational sequence proceeds from step S11 to step S12. In step S12, feeder determination device 8 performs a guide process. Specifically, feeder determination device 8 indicates there is no feeder 3 that satisfies the condition for satisfactorily performing the pickup operation of the component of type P5 of size Sz4. Thereafter, the execution of the operational sequence is returned to step S5.

In the fifth instance of step S5, a component of type P6 of the largest size Sz5 is selected. In the next step, S6, since management of components of size Sz5 is not necessary, the execution of the operational sequence is branched to step S13. In step S13, feeder determination device 8 determines the combination of component of type P6 of size Sz5 and remaining feeders 3 of identification information F6 or F7. Thus, the determination process of all the components is finished, and the operational sequence is finished.

If the actual pickup rate Apf of performance result data 73 is good, feeder determination device 8 of the first embodiment determines the combination of the size of the component and feeder 3 based on the actual pickup rate Apf of performance result data 73. Then, when the determination based on the actual pickup rate Apf cannot be performed, feeder determination device 8 performs the determination based on the ability of positional accuracy Bpf. That is, feeder determination device 8 advances the determination process on the premise that the actual pickup rate Apf is more reliable than the ability of position accuracy Bpf. As support for this premise, a case has actually occurred in which an expected actual pickup rate Apf could not be obtained even when feeder 3 having a high ability of positional accuracy Bpf was used.

In the feeder determination method and feeder determination device 8 of the first embodiment, when there is performance result data 73 using sizes Sz1 to Sz5 of the components used for the mounting operation to be performed in combination with candidate feeder 3, the combination of sizes Sz1 to Sz5 of the components and feeder 3 are determined based on the supply performance record of feeder 3. Therefore, an appropriate combination is reliably determined based on the supply performance record of the highly reliable feeder 3.

In addition, when there is no performance result data 73 or when there are not enough supply performance records even if there is performance result data 73, the combination is determined based on the supply quality of feeder 3. Therefore, an appropriate combination is determined based on the supply qualilty having a large correlation with supply performance records. Therefore, an appropriate feeder 3 corresponding to sizes Sz1 to Sz5 of the components is determined regardless of whether there is a performance result.

In addition, in a case where there is performance result data 73, since the determination process is performed using the record pickup rate Apf in the data, it is not necessary to measure the supply qualilty of feeder 3, and in addition, it is not necessary to accurately manage the present supply quality. Accordingly, a significant labor saving is achieved when determining the combination of sizes Sz1 to Sz5 of the components and feeder 3.

### 4. Feeder determination method of a second embodiment

Next, a feeder determination method of the second embodiment will be mainly described with reference to Fig. 9, which differs from the first embodiment. The high/low reliability of the pickup operation of the component is not only related to the quality of feeder 3 but also to the quality of suction nozzle 46 and mounting head 45. In the second embodiment, in the performance record-based determination step S8, a combination of suction nozzles 46 is added to the combination of component size and feeder 3. Fig. 9 shows in detail a portion of the table shown in Fig. 7. As shown in the figure, in the second embodiment, the actual pickup rate Apf is individually obtained for the combination of feeder 3 and multiple suction nozzles 46.

In Fig. 9, a combination of two feeders 3 of identification information F1, F2 and three suction nozzles 46 of identification information N1 to N3 is exemplified. As a breakdown of the actual pickup rate Apf (99.94%) of the component of size Sz1 of feeder 3 of identification information F1, the actual pickup rates Apf individually obtained by suction nozzles 46 of identification information N1 to N3 are indicated as 99.97%, 99.95%, and 99.92%, respectively. Similarly, as a breakdown of the actual pickup rate Apf (99.92%) of the component of size Sz1 of feeder 3 of identification information F2, the actual pickup rates Apf individually obtained by suction nozzles 46 of identification information N1 to N3 are indicated as 99.94%, 99.91%, and 99.93%, respectively.

In the first step, S22, of the first embodiment, performance record-based determination section 83 employs a combination of a component of type P1 of size Sz1 and feeder 3 of identification information F1. In the second embodiment, performance record-based determination section 83 further adds a combination of suction nozzles 46 of identification information N1 having the highest actual pickup rate Apf (99.97%) obtained individually. As a result, in the mounting operation of component mounting device 1, feeder 3 of identification information F1 and suction nozzle 46 of identification information N1 are combined and used for the component of type P1 of size Sz1.

Similarly, performance record-based determination section 83 employs a combination of a component of type P2 of size Sz1 and feeder 3 of identification information F2. In addition, performance record-based determination section 83 adds a combination of suction nozzles 46 of identification information N3 having a high performance result pickup rate Apf (99.93%) obtained individually, excluding suction nozzles 46 of determined identification information N1. As a result, in the mounting operation of component mounting device 1, feeder 3 of identification information F2 and suction nozzle 46 of identification information N3 are combined and used for the component of type P2 of size Sz1.

Although not described in detail, the combination of feeder 3 and suction nozzle 46 is also determined for the components of types P3 to P6. It should be noted that suction nozzle 46 may be commonly used for multiple types of components depending on conditions such as the number of suction nozzles provided on mounting head 45, the total number of component types, and the like. For example, suction nozzle 46 of identification information N1 may be commonly used for components of types P1 and P2 of size Sz1. In addition, a combination of feeder 3 and mounting head 45 with respect to a certain component may be determined by a similar determination method.

In the feeder determination method of the second embodiment, in the performance record-based determination step S8, a combination of suction nozzle 46 is added to the combination of the size of the component and feeder 3 based on the performance result pickup rate Apf individually obtained for the combination of feeder 3 and suction nozzle 46. Accordingly, an appropriate combination of feeder 3 and suction nozzle 46 related to the reliability of the pickup operation of the component is determined.

### 5. Other applications and modifications of the embodiments

Many types of components and combinations of feeder 3 and suction nozzle 46 are actually determined as compared with those described in the embodiment. In the first embodiment, even if the sizes of the components are the same, in a case where the required pickup rate Areq and the required positional accuracy Breq are different from each other for each type, steps S4 to S14 of the operational sequence shown in Fig. 4 are repeated for each type of component. At this time, the performance result pickup rate Apf is preferably a pickup rate by type required for each type of component.

Further, when the order in which the sizes of the components are small does not match with the order in which the required pickup rates Areq and the required positional accuracies Breq are high, in step S5, components are selected sequentially from components having large required pickup rates Areq and large required position accuracies Breq. In the first embodiment, the actual pickup rate Apf by component size is used as the supply performance result (see Fig. 7). Alternatively, an average actual pickup rate determined regardless of the size or type of the component may be used. As a result, the management of database 72 and the determination process of the operational sequence are simplified.

In addition, in step S3 of Fig. 4, feeder determination device 8 excludes feeder 3 that cannot be used immediately from the candidates, but there may be another method. That is, feeder determination device 8 may execute the operational sequence by including feeder 3 that cannot be used immediately among the candidates. In this aspect, when determining the combination of the size or type of feeder 3 and the component, feeder determination device 8 sends out a notification to the effect that "feeder 3 cannot be used immediately". In addition, various applications and modifications can be made to the embodiments and the application modes.

### Reference Signs List

1: Component mounting device, 3: Feeder, 32: Supply position, 6: Control device, 71: Management computer, 73: Performance result data, 75: Measurement jig, 8: Feeder determination device, 81: Performance result registration section, 82: Performance result search section, 83: Performance record-based determination section, 84: Quality-based determination section, S1: Performance result registration step, S7: Performance result search step, S8: Performance record-based determination step, S10: Quality-based determination step, F1-F7: Identification information, N1-N3: Identification information, P1-P6: Type, Sz1-Sz5: Size, Apf: Performance result pickup rate, Areq: Required pickup rate, Bpf, Bpf 1-Bpf7: Ability of positional accuracy, Breq: Required positional accuracy

## Claims

1. A feeder determination method, comprising:
a performance result registration step (S1) of registering performance result data in a database associating a size (Sz1-Sz5) or type (P1-P6) of a component used in a mounting operation that has been performed in a component mounting machine (1) with identification information (F1-F7) of a feeder (3) that supplied the component using a carrier tape;
a performance result search step (S7) of searching for whether candidate data matches any of the performance result data in the database, the candidate data being a combination of a size (Sz1-Sz5) or type (P1-P6) of a component used in a mounting operation to be performed and identification information (F1-F7) of a candidate feeder to supply the component; and
a performance record-based determination step (S8) of determining a combination of a size (Sz1-Sz5) or type (P1-P6) of a component and a feeder (3) based on a supply performance record in the mounting operation that has been performed with the feeder (3) that is to become a candidate when the candidate data matches at least one piece of the performance result data, wherein the supply performance record of the feeder (3) is related to a recorded performance result pickup rate (Apf) for the combined size or type (P1-P6) of a component;
**characterized by**
a quality-based determination step (S10) of determining a combination of a size (Sz1-Sz5) or type (P1-P6) of a component and a feeder (3) based on a supply quality of the feeder (3) when the candidate data does not match any of the performance result data, wherein the supply quality of the feeder (3) is related to an ability of positional accuracy (Bpf1-Bpf7) of the feeder (3).

2. The feeder determination method of claim 1, wherein
the ability of positional accuracy (Bpf1-Bpf7) indicates a positional accuracy when the carrier tape is fed to set the component at a predetermined supply position (32), and
the combination with the feeder (3) having a higher ability of positional accuracy (Bpf1-Bpf7) than the required positional accuracy (Breq), which is the positional accuracy necessary for the size (Sz1-Sz5) or type (P1-P6) of the component, is employed in the quality-based determination step (S10).

3. The feeder determination method of claim 2, wherein
the component to be mounted has a multiple of the sizes (Sz1-Sz5) or types (P1-P6), and, in the quality-based determining step, the combination with the feeder (3) having the higher ability of positional accuracy (Bpf1-Bpf7) is employed sequentially from the size (Sz1-Sz5) or type (P1-P6) having the higher required positional accuracy (Breq).

4. The feeder determination method of claim 2 or 3, wherein
the ability of positional accuracy (Bpf1-Bpf7) is acquired by measurement performed by installing the feeder (3) in a measurement jig (75) or by measurement during the mounting operation performed by installing the feeder (3) in the component mounting machine (1).

5. The feeder determination method of any one of claims 1 to 4, wherein
the performance result pickup rate (Apf) is the probability that a suction nozzle responsible for the mounting operation succeeds in picking up the component, and, in the performance record-based step, the combination with the feeder (3) having a higher performance result pickup rate (Apf) than the required pickup rate (Areq), which is a pickup rate required for the size (Sz1-Sz5) or type (P1-P6) of the component, is employed.

6. The feeder determination method of claim 5, wherein the components used for the mounting operation to be executed has a multiple of the sizes (Sz1-Sz5) or the types (P1-P6), and, in the performance record-based determination step (S8), the combination with the feeder (3) having the higher performance result pickup rate (Apf) is used in order from the size (Sz1-Sz5) or the type (P1-P6) having the higher required pickup rate (Areq).

7. The feeder determination method of claim 5 or 6, wherein
the performance result pickup rate (Apf) is individually determined for a combination of the feeder (3) and at least one of the suction nozzle and the mounting head that holds the suction nozzle, and a combination of at least one of the suction nozzle and the mounting head is added to the combination of the size (Sz1-Sz5) or type (P1-P6) of the component and the feeder (3) based on the individually determined performance result pickup rate (Apf) in the performance record-based determination step (S8).

8. The feeder determination method of any one of claims 5 to 7, wherein the performance result pickup rate (Apf) is determined regardless of the size (Sz1-Sz5) and type (P1-P6) of the component or is determined for each size (Sz1-Sz5) or type (P1-P6) of the component.

9. The feeder determination method of any one of claims 1 to 8, wherein, when a candidate feeder (3) cannot be used immediately, the feeder (3) is excluded from the candidates and combinations with the size (Sz1-Sz5) or type (P1-P6) of the component are avoided, or, when a combination with the size (Sz1-Sz5) or type (P1-P6) of the component is determined, notification is sent out indicating the candidate feeder (3) cannot be used immediately.

10. A feeder determination device (8), comprising:
a performance result registration section (81) configured to register performance result data (73) in a database associating a size (Sz1-Sz5) or type (P1-P6) of a component used in a mounting operation that has been performed in a component mounting machine (1) with identification information (F1-F7) of a feeder (3) that supplied the component using a carrier tape;
a performance result search section (82) configured to search for whether candidate data matches any of the performance result data (73) in the database, the candidate data being a combination of a size (Sz1-Sz5) or type (P1-P6) of a component used in a mounting operation to be performed with identification information (F1-F7) of a candidate feeder (3) to supply the component; and
a performance record-based determination section (83) configured to determine a combination of a size (Sz1-Sz5) or type (P1-P6) of a component and a feeder (3) based on a supply performance record in the mounting operation that has been performed with the feeder (3) when the candidate data matches at least one piece of the performance result data (73), wherein the supply performance record of the feeder (3) is related to a recorded performance result pickup rate (Apf) for the combined size or type (P1-P6) of a component;
the feeder determination device (8) **characterized in that** the feeder determination device (8) comprises
a quality-based determination section (84) configured to determine a combination of a size (Sz1-Sz5) or type (P1-P6) of a component and a feeder (3) based on a supply quality of the feeder (3) when the candidate data does not match any of the performance result data (73), wherein the supply quality of the feeder (3) is related to an ability of positional accuracy (Bpf1-Bpf7) of the feeder (3).

## Patentansprüche

1. Ein Verfahren zur Bestimmung einer Zuführung, das Folgendes umfasst:
einen Leistungsergebnis-Registrierungsschritt (S1) des Registrierens von Leistungsergebnisdaten in einer Datenbank, die eine Größe (Sz1-Sz5) oder einen Typ (P1-P6) eines Bauteils, das in einem Montagevorgang verwendet wird, der in einer BauteilMontagemaschine (1) durchgeführt worden ist, mit Identifikationsinformationen (F1-F7) einer Zuführung (3) verbindet, der das Bauteil unter Verwendung eines Trägerbandes zugeführt hat;
einen Leistungsergebnissuchschritt (S7) des Suchens danach, ob Kandidatendaten mit irgendwelchen der Leistungsergebnisdaten in der Datenbank übereinstimmen, wobei die Kandidatendaten eine Kombination einer Größe (Sz1-Sz5) oder eines Typs (P1-P6) eines Bauteils, das in einem durchzuführenden Montagevorgang verwendet wird, und von Identifikationsinformationen (F1-F7) eines Zuführungskandidaten zur Lieferung des Bauteils sind; und
einen leistungsdatensatzbasierten Bestimmungsschritt (S8) des Bestimmens einer Kombination einer Größe (Sz1-Sz5) oder eines Typs (P1-P6) einer Komponente und einer Zuführung (3) auf der Grundlage eines Zuführleistungsdatensatzes in dem Montagevorgang, der mit der Zuführung (3) durchgeführt worden ist, die ein Kandidat werden soll, wenn die Kandidatendaten mit mindestens einem Teil der Leistungsergebnisdaten übereinstimmen, wobei der Zuführleistungsdatensatz der Zuführung (3) mit einer aufgezeichneten Leistungsergebnisaufnahmerate (Apf) für die kombinierte Größe oder den kombinierten Typ (P1-P6) einer Komponente in Beziehung steht;
**gekennzeichnet durch**
einen qualitätsbasierten Bestimmungsschritt (S10) des Bestimmens einer Kombination einer Größe (Sz1-Sz5) oder eines Typs (P1-P6) einer Komponente und einer Zuführung (3) auf der Grundlage einer Zuführungsqualität der Zuführung (3), wenn die Kandidatendaten mit keinem der Leistungsergebnisdaten übereinstimmen, wobei die Zuführungsqualität der Zuführung (3) auf eine Fähigkeit der Positionsgenauigkeit (Bpf1-Bpf7) der Zuführung (3) bezogen ist.

2. Verfahren zur Bestimmung der Zuführung nach Anspruch 1, wobei
die Fähigkeit der Positioniergenauigkeit (Bpf1-Bpf7) eine Positioniergenauigkeit angibt, wenn das Trägerband zugeführt wird, um das Bauteil an einer vorbestimmten Zuführposition (32) zu setzen, und
die Kombination mit der Zuführung (3), die eine höhere Fähigkeit der Positioniergenauigkeit (Bpf1-Bpf7) als die erforderliche Positioniergenauigkeit (Breq) aufweist, die die für die Größe (Sz1-Sz5) oder den Typ (P1-P6) des Bauteils erforderliche Positioniergenauigkeit ist, wird im qualitätsbasierten Bestimmungsschritt (S10) verwendet.

3. Verfahren zur Bestimmung der Zuführung nach Anspruch 2, wobei
das zu montierende Bauteil ein Vielfaches der Größen (Sz1-Sz5) oder Typen (P1-P6) aufweist, und in dem qualitätsbasierten Bestimmungsschritt die Kombination mit der Zuführung (3) mit der höheren Fähigkeit der Positioniergenauigkeit (Bpf1-Bpf7) nacheinander von der Größe (Sz1-Sz5) oder dem Typ (P1-P6) mit der höheren erforderlichen Positioniergenauigkeit (Breq) eingesetzt wird.

4. Verfahren zur Bestimmung der Zuführung nach Anspruch 2 oder 3, wobei
die Fähigkeit der Positionsgenauigkeit (Bpf1-Bpf7) wird durch eine Messung, die durch die Installation der Zuführung (3) in einer Messvorrichtung (75) durchgeführt wird, oder durch eine Messung während des Montagevorgangs, die durch die Installation der Zuführung (3) in der Bauteilmontagemaschine (1) durchgeführt wird, erworben.

5. Verfahren zur Bestimmung der Zuführung nach einem der Ansprüche 1 bis 4, wobei
die Leistungsergebnis-Aufnahmerate (Apf) die Wahrscheinlichkeit ist, dass es einer für den Montagevorgang zuständigen Saugdüse gelingt, das Bauteil aufzunehmen, und im leistungserfassungsbasierten Schritt die Kombination mit der Zuführung (3) mit einer höheren Leistungsergebnis-Aufnahmerate (Apf) als der erforderlichen Aufnahmerate (Areq), die eine für die Größe (Sz1-Sz5) oder Art (P1-P6) des Bauteils erforderliche Aufnahmerate ist, verwendet wird.

6. Verfahren zur Bestimmung der Zuführung nach Anspruch 5, wobei die für den auszuführenden Montagevorgang verwendeten Komponenten ein Vielfaches der Größen (Sz1-Sz5) oder der Typen (P1-P6) aufweisen, und in dem auf dem Leistungsnachweis basierenden Bestimmungsschritt (S8) die Kombination mit dem Zuführer (3) mit der höheren Leistungsergebnis-Aufnahmerate (Apf) in der Reihenfolge von der Größe (Sz1-Sz5) oder dem Typ (P1-P6) mit der höheren erforderlichen Aufnahmerate (Areq) verwendet wird.

7. Verfahren zur Bestimmung der Zuführung nach Anspruch 5 oder 6, wobei
die Leistungsergebnis-Aufnahmerate (Apf) individuell für eine Kombination aus dem Zuführer (3) und mindestens einer von der Saugdüse und dem Montagekopf, der die Saugdüse hält, bestimmt wird, und eine Kombination von mindestens einer von der Saugdüse und dem Montagekopf zu der Kombination der Größe (Sz1-Sz5) oder des Typs (P1-P6) des Bauteils und der Zuführung (3) auf der Grundlage der individuell bestimmten Leistungsergebnis-Aufnahmerate (Apf) in dem auf der Leistungsaufzeichnung basierenden Bestimmungsschritt (S8) addiert wird.

8. Verfahren zur Bestimmung der Zuführung nach einem der Ansprüche 5 bis 7, wobei die Leistungsergebnis-Aufnahmerate (Apf) unabhängig von der Größe (Sz1-Sz5) und dem Typ (P1-P6) des Bauteils bestimmt wird oder für jede Größe (Sz1-Sz5) oder jeden Typ (P1-P6) des Bauteils bestimmt wird.

9. Verfahren zur Bestimmung der Zuführung nach einem der Ansprüche 1 bis 8, wobei, wenn ein in Frage kommender Zuführer (3) nicht sofort verwendet werden kann, der Zuführer (3) von den in Frage kommenden Zuführern ausgeschlossen wird und Kombinationen mit der Größe (Sz1-Sz5) oder dem Typ (P1-P6) des Bauteils vermieden werden, oder, wenn eine Kombination mit der Größe (Sz1-Sz5) oder dem Typ (P1-P6) des Bauteils bestimmt wird, eine Benachrichtigung gesendet wird, dass der in Frage kommende Zuführer (3) nicht sofort verwendet werden kann.

10. Vorrichtung zur Bestimmung der Zuführung (8), umfassend:
einen Leistungsergebnisregistrierungsabschnitt (81), der so konfiguriert ist, dass er Leistungsergebnisdaten (73) in einer Datenbank registriert, die eine Größe (Sz1-Sz5) oder einen Typ (P1-P6) eines Bauteils, das in einem Montagevorgang verwendet wird, der in einer Bauteilmontagemaschine (1) durchgeführt wurde, mit Identifikationsinformationen (F1-F7) einer Zuführung (3), die das Bauteil unter Verwendung eines Trägerbandes zugeführt hat, verknüpft;
einen Leistungsergebnissuchabschnitt (82), der so konfiguriert ist, dass er sucht, ob Kandidatendaten mit irgendwelchen der Leistungsergebnisdaten (73) in der Datenbank übereinstimmen, wobei die Kandidatendaten eine Kombination einer Größe (Sz1-Sz5) oder eines Typs (P1-P6) einer Komponente, die in einem durchzuführenden Montagevorgang verwendet wird, mit Identifizierungsinformationen (F1-F7) einer Kandidatenzuführung (3) zur Lieferung der Komponente sind; und
einen leistungsdatensatzbasierten Bestimmungsabschnitt (83), der so konfiguriert ist, dass er eine Kombination einer Größe (Sz1-Sz5) oder eines Typs (P1-P6) einer Komponente und einer Zuführung (3) auf der Grundlage eines Zuführleistungsdatensatzes in dem Montagevorgang, der mit der Zuführung (3) durchgeführt wurde, bestimmt, wenn die Kandidatendaten mit mindestens einem Teil der Leistungsergebnisdaten (73) übereinstimmen, wobei der Zuführleistungsdatensatz der Zuführung (3) mit einer aufgezeichneten Leistungsergebnisaufnahmerate (Apf) für die kombinierte Größe oder den Typ (P1-P6) einer Komponente in Beziehung steht;
die Vorrichtung zur Bestimmung der Zuführung (8), **dadurch gekennzeichnet, dass** die Vorrichtung zur Bestimmung der Zuführung (8) umfasst
einen qualitätsbasierten Bestimmungsabschnitt (84), der so konfiguriert ist, dass er eine Kombination einer Größe (Sz1-Sz5) oder eines Typs (P1-P6) einer Komponente und einer Zuführung (3) auf der Grundlage einer Zuführungsqualität der Zuführung (3) bestimmt, wenn die Kandidatendaten mit keinem der Leistungsergebnisdaten (73) übereinstimmen, wobei die Zuführungsqualität der Zuführung (3) mit einer Fähigkeit der Positionsgenauigkeit (Bpf1-Bpf7) der Zuführung (3) in Beziehung steht.

## Revendications

1. Procédé de détermination de chargeur, comprenant :
une étape d'enregistrement des résultats de performance (S1) consistant à enregistrer des données de résultat de performance dans une base de données associant une taille (Sz1-Sz5) ou un type (P1-P6) de composant utilisé dans une opération de montage effectuée dans une machine de montage de composants (1) à des informations d'identification (F1-F7) d'un chargeur (3) qui a fourni le composant à l'aide d'une bande de support ;
une étape de recherche des résultats de performance (S7) consistant à rechercher si des données candidates correspondent à l'une des données de résultat de performance dans la base de données, les données candidates étant une combinaison d'une taille (Sz1-Sz5) ou d'un type (P1-P6) de composant utilisé dans une opération de montage à effectuer et d'informations d'identification (F1-F7) d'un chargeur candidat pour l'approvisionnement du composant ; et
une étape de détermination basée sur l'enregistrement des performances (S8), consistant à déterminer une combinaison de taille (Sz1-Sz5) ou de type (P1-P6) d'un composant et d'un chargeur (3) sur la base d'un enregistrement des performances d'approvisionnement dans l'opération de montage qui a été effectuée avec le chargeur (3) qui doit devenir un candidat lorsque les données du candidat correspondent à au moins un élément des données de résultat de performance, dans lequel l'enregistrement des performances d'approvisionnement du chargeur (3) est lié à un taux de collecte du résultat de performance (Apf) enregistré pour la taille ou le type (P1-P6) combinés d'un composant ;
**caractérisé par** une étape de détermination basée sur la qualité (S10) consistant à déterminer une combinaison de taille (Sz1-Sz5) ou de type (P1-P6) d'un composant et d'un chargeur (3) sur la base d'une qualité d'approvisionnement du chargeur (3) lorsque les données candidates ne correspondent à aucune des données de résultat de performance, dans lequel la qualité d'approvisionnement du chargeur (3) est liée à une capacité de précision de positionnement (Bpf1-Bpf7) du chargeur (3).

2. Procédé de détermination de chargeur selon la revendication 1, dans lequel
la capacité de précision de positionnement (Bpf1-Bpf7) indique une précision de positionnement lorsque la bande de support est approvisionnée pour placer le composant à une position d'approvisionnement prédéterminée (32), et
la combinaison avec le chargeur (3) ayant une capacité de précision de positionnement (Bpf1-Bpf7) supérieure à la précision de positionnement requise (Breq), qui est la précision de positionnement nécessaire pour la taille (Sz1-Sz5) ou le type (P1-P6) du composant, est utilisée dans l'étape de détermination basée sur la qualité (S10).

3. Procédé de détermination de chargeur selon la revendication 2, dans lequel
le composant à monter a un multiple des tailles (Sz1-Sz5) ou des types (P1-P6), et, dans l'étape de détermination basée sur la qualité, la combinaison avec le chargeur (3) ayant la plus grande capacité de précision de positionnement (Bpf1-Bpf7) est employée séquentiellement à partir de la taille (Sz1-Sz5) ou du type (P1-P6) ayant la plus grande précision de positionnement requise (Breq).

4. Procédé de détermination de chargeur selon la revendication 2 ou 3, dans lequel
la capacité de précision de positionnement (Bpf1-Bpf7) est acquise par une mesure effectuée en installant le chargeur (3) dans un gabarit de mesure (75) ou par une mesure pendant l'opération de montage effectuée en installant le chargeur (3) dans la machine de montage de composants (1).

5. Procédé de détermination de chargeur selon l'une quelconque des revendications 1 à 4, dans lequel
le taux de collecte du résultat de performance (Apf) est la probabilité qu'une buse d'aspiration responsable de l'opération de montage réussisse à prélever le composant, et, dans l'étape basée sur l'enregistrement des performances, la combinaison avec le chargeur (3) ayant un taux de collecte du résultat de performance (Apf) plus élevé que le taux de collecte requis (Areq), qui est un taux de collecte requis pour la taille (Sz1-Sz5) ou le type (P1-P6) du composant, est employée.

6. Procédé de détermination de chargeur selon la revendication 5, dans lequel les composants utilisés pour l'opération de montage à exécuter ont un multiple des tailles (Sz1-Sz5) ou des types (P1-P6), et, dans l'étape de détermination basée sur l'enregistrement des performances (S8), la combinaison avec le chargeur (3) ayant le taux de collecte du résultat de performance (Apf) le plus élevé est utilisée dans l'ordre à partir de la taille (Sz1-Sz5) ou du type (P1-P6) ayant le taux de collecte requis (Areq) le plus élevé.

7. Procédé de détermination de chargeur selon la revendication 5 ou 6, dans lequel
le taux de collecte du résultat de performance (Apf) est déterminé individuellement pour une combinaison du chargeur (3) et au moins l'un de la buse d'aspiration et de la tête de montage qui maintient la buse d'aspiration, et une combinaison d'au moins l'une de la buse d'aspiration et de la tête de montage est ajoutée à la combinaison de la taille (Sz1-Sz5) ou du type (P1-P6) du composant et du chargeur (3) sur la base du taux de collecte du résultat de performance (Apf) déterminé individuellement lors de l'étape de détermination basée sur l'enregistrement des performances (S8).

8. Procédé de détermination de chargeur selon l'une quelconque des revendications 5 à 7, dans lequel le taux de collecte du résultat de performance (Apf) est déterminé indépendamment de la taille (Sz1-Sz5) et du type (P1-P6) du composant ou est déterminé pour chaque taille (Sz1-Sz5) ou type (P1-P6) du composant.

9. Procédé de détermination de chargeur selon l'une quelconque des revendications 1 à 8, dans lequel, lorsqu'un chargeur (3) candidat ne peut pas être utilisé immédiatement, le chargeur (3) est exclu des candidats et les combinaisons avec la taille (Sz1-Sz5) ou le type (P1-P6) du composant sont évitées, ou, lorsqu'une combinaison avec la taille (Sz1-Sz5) ou le type (P1-P6) du composant est déterminée, une notification est envoyée pour indiquer que le chargeur (3) candidat ne peut pas être utilisé immédiatement.

10. Dispositif de détermination de chargeur (8), comprenant :
une section d'enregistrement des résultats de performance (81) configurée pour enregistrer des données de résultat de performance (73) dans une base de données associant une taille (Sz1-Sz5) ou un type (P1-P6) de composant utilisé dans une opération de montage effectuée dans une machine de montage de composants (1) à des informations d'identification (F1-F7) d'un chargeur (3) qui a fourni le composant à l'aide d'une bande de support ;
une section de recherche des résultats de performance (82) configurée pour rechercher si des données candidates correspondent à l'une des données de résultat de performance (73) dans la base de données, les données candidates étant une combinaison d'une taille (Sz1-Sz5) ou d'un type (P1-P6) de composant utilisé dans une opération de montage à effectuer avec des informations d'identification (F1-F7) d'un chargeur (3) candidat pour fournir le composant ; et
une section de détermination basée sur les performances (83) configurée pour déterminer une combinaison de taille (Sz1-Sz5) ou de type (P1-P6) d'un composant et d'un chargeur (3) sur la base d'un enregistrement des performances d'approvisionnement dans l'opération de montage qui a été effectuée avec le chargeur (3) lorsque les données candidates correspondent à au moins un élément des données de résultat de performance (73), l'enregistrement des performances d'approvisionnement du chargeur (3) étant lié à un taux de collecte du résultat de performance (Apf) enregistré pour la taille ou le type (P1-P6) combinés d'un composant ;
le dispositif de détermination de chargeur (8) **caractérisé en ce que** le dispositif de détermination de chargeur (8) comprend
une section de détermination basée sur la qualité (84) configurée pour déterminer une combinaison de taille (Sz1-Sz5) ou de type (P1-P6) d'un composant et d'un chargeur (3) sur la base d'une qualité d'approvisionnement du chargeur (3) lorsque les données candidates ne correspondent à aucune des données de résultat de performance (73), dans lequel la qualité d'approvisionnement du chargeur (3) est liée à une capacité de précision de positionnement (Bpf1-Bpf7) du chargeur (3).
